(19) Europäisches Patentamt

European Patent Office

Office européen des brevets

(11) Veröffentlichungsnummer: **0 110 063 B1**

(12) # EUROPÄISCHE PATENTSCHRIFT

(45) Veröffentlichungstag der Patentschrift:
**06.09.89**

(21) Anmeldenummer: **83110004.5**

(22) Anmeldetag: **06.10.83**

(51) Int. Cl.⁴: **G 12 B 11/00, G 01 D 11/28**

(54) Anordnung zur Beleuchtung der Anzeigemittel eines Messgerätes mittels Durchlicht.

(30) Priorität: **13.10.82 DE 3237883**

(43) Veröffentlichungstag der Anmeldung:
**13.06.84 Patentblatt 84/24**

(45) Bekanntmachung des Hinweises auf die Patenterteilung:
**06.09.89 Patentblatt 89/36**

(84) Benannte Vertragsstaaten:
**DE FR GB IT**

(56) Entgegenhaltungen:
**EP-A- 0 006 361**
**FR-A- 2 422 147**
**GB-A- 2 007 842**

(73) Patentinhaber: **Mannesmann Kienzle GmbH,**
**Postfach 1640 Heinrich-Hertz-Strasse,**
**D-7730 Villingen-Schwenningen (DE)**

(72) Erfinder: **Endler, Max, Kopsbühl 62,**
**D-7730 Villingen-Schwenningen (DE)**
Erfinder: **Maier, Wolfgang, Kopsbühl 80,**
**D-7730 Villingen-Schwenningen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft eine Anordnung zur Durchlichtbeleuchtung der Anzeigemittel eines Meßgerätes mit wenigstens einer im Inneren des Meßgerätes angeordneten Lichtquelle und einem der Lichtquelle zugeordneten, im wesentlichen den Umrissen eines Skalen- und Ziffernblattes der Anzeigemittel des Meßgerätes entsprechenden, scheibenförmigen Lichtleitkörper, welcher der Einkoppelung von Licht in wenigstens einen lichtleitenden Zeiger dient, dessen Welle durch den Lichtleitkörper hindurchgreift.

Bekanntlich bietet eine Durchlichtbeleuchtung von Anzeigemitteln, d. h. von Skalen und Zeigern analog anzeigender Meßgeräte im Gegensatz zur Auflichtbeleuchtung eine gleichmäßig gute Lesbarkeit der angezeigten Meßwerte innerhalb eines relativ großen Raumwinkels. Dies ist im wesentlichen darauf zurückzuführen, daß eine derartige Beleuchtung mittels Durchlicht bei ausreichendem Kontrast blend- und lichthoffrei ausführbar ist. Die Durchleuchtung der Skalen ist im allgemeinen auch in ungünstigen Fällen, d. h. bei großen Gerätequerschnitten und kompakter Bauweise, relativ unkritisch, da die Verteilung des Lichtes einer oder mehrerer, im Innern des Meßgerätes angeordneter Lichtquellen mittels eines lichtleitenden und im Skalenbereich lichtstreuenden Lichtleitkörpers erfolgt. Dabei können die Skalenelemente entweder unmittelbar auf dem Lichtleitkörper aufgebracht sein, oder es ist ein dem Lichtleitkörper zugeordnetes, vorzugsweise aus einem lichtstreuenden Werkstoff hergestelltes Skalen- und Ziffernblatt vorgesehen. Helligkeitsunterschiede zwischen dem einer Lichtquelle benachbarten Ziffernblattbereich und Bereichen des Ziffernblattes mit größerem Abstand von der Lichtquelle sind bekanntlich dadurch ausgleichbar, daß auf der Rückseite des Ziffernblattes ein Rasterdruck vorgesehen ist, dessen Raster mit zunehmendem Abstand von der Lichtquelle weitmaschiger ausgebildet ist.

Das eigentliche Problem stellt die Durchlichtbeleuchtung des oder der dem Ziffernblatt zugeordneten Zeiger dar, wobei eine bezüglich der Beleuchtungsqualität besonders vorteilhafte Lösung, nämlich eine Lösung gemäß dem DE-GM 7 901 406, in vielen Anwendungsfällen ausscheidet. Diese Lösung sieht eine vor einer Lichtstreuscheibe bewegte, lichtundurchlässige Scheibe vor, an der ein Zeiger durch Schlitzen der Scheibe, oder wenn diese aus lichtdurchlässigem Material besteht, durch geeignetes Abdecken der Scheibe ausgeblendet ist. Mit einer derartigen Lösung ist aber weder ein eine Skala übergreifender Zeiger realisierbar, noch lassen sich mehrere, konzentrisch angeordnete Zeiger ausbilden.

Muß demgegenüber das der Zeigerbeleuchtung dienende Licht über die Nabe des entsprechend lichtdurchlässig ausgebildeten Zeigers eingekoppelt werden, so besteht, von der Forderung nach einer möglichst gleichmäßigen Ausleuchtung der Zeigerfahne abgesehen, das Problem einer ausreichend hohen Lichtmenge an der der Zeigernabe ausgebildeten Übernahmefläche. Erschwerend bezüglich einer Lösung dieses Problems sind insbesondere designerische Forderungen, die, was nebenbei den Parallaxeneffekt verringert, geringe Bauhöhe und feine Zeigerfahnen mit möglichst kleinem Zeigerauge vorsehen, so daß lediglich Zeigernaben mit relativ kleinem Durchmesser und mit kleinen Lichtübernahmeflächen verwirklichbar sind. Hinzu kommt, daß die als Lichtquellen dienenden Lampen vielfach nicht in unmittelbarer Nähe der Durchführung der Zeigerwelle durch Lichtleitkörper und Ziffernblatt angeordnet werden können und insbesondere bei Geräten mit hoher Packungsdichte der Wärmeentwicklung wegen bezüglich ihrer Leistungsaufnahme weitestgehend minimiert sein sollten.

Eine beleuchtungstechnisch ausgezeichnete Lösung zeigt die DE-C 827 715 mit einer in Blickrichtung vor dem Zeiger und zentrisch zur Zeigerachse angeordneten Lichtquelle. Es leuchtet ein, daß aus ästhetischen Gründen mit einer derartigen Lösung ein marktfähiges Gerät nicht realisierbar ist. Andererseits scheiden aber auch Lösungen aus, die gemäß dem DE-GM 1 944 977 relativ großvolumige, durch den dem Ziffernblatt zugeordneten Lichtleiter in den Geräteraum hindurchgreifende Zeigernaben vorsehen, da einerseits die Voraussetzungen für die angestrebte designerische Gestaltung mangelhaft sind, andererseits ein entsprechender Freiraum für die direkte Lichtverbindung zwischen Lichtquelle und Zeigernabe in vielen Fällen nicht gegeben ist.

Stellvertretend für Lösungen, bei denen der Skalenträger als Lichtleitkörper ausgebildet ist, zusätzlich aber auch ein Lichtleitkörper für die Zeigerbeleuchtung vorgesehen ist, sei die DE-C 1 145 808 genannt. Bei derartigen Lösungen ist abgesehen von dem gegenüber einem einzigen Lichtleiter für Ziffernblatt- und Zeigerbeleuchtung erforderlichen zusätzlichen Raumbedarf und dem erheblichen Teile- und Montageaufwand ein voluminöser Zeiger erforderlich, und zwar deshalb, weil das in den für die Zeigerbeleuchtung vorgesehenen, gemäß dem genannten Patent scheibenförmigen Lichtleitkörper eingespeiste und in diesem Lichtleitkörper streuende Licht nur zu einem geringen Bruchteil von der Zeigernabe übernommen werden kann.

Wie beispielsweise die DE-A 2 913 139 zeigt, ist es aber auch bekannt, unabhängig von den Mitteln zur Beleuchtung des Zifferblattes einen Lichtleitkörper mit lichtsammelnder Wirkung vorzusehen und diesem eine ausschließlich der Beleuchtung des Zeigers dienende Lichtquelle zuzuordnen. In diesem Falle wird – abgesehen vom Raumbedarf und Teilaufwand – insbesondere durch Polieren verschiedener Flächen und durch Justieren des vorgesehenen Lichtkanals zusätzlicher Fertigungsaufwand erforderlich.

Mit der EP-A 0 006 361 ist eine Lösung bekannt geworden, die ebenfalls eine Lichtkonzentration in Richtung Zeigerdurchführung durch den Lichtleitkörper bewirkt, indem an dem Lichtleitkörper zwei elliptisch geformte Ansätze ausgebildet und die Lichtquellen in geeigneter Weise diesen Ansätzen zugeordnet sind. Diese Lösung sieht zwar nur ein einziges Teil, den Lichtleitkörper, vor; für den relativ engen Öffnungsquerschnitt üblicher anzeigender Meßgeräte ist ein derartiger Lichtleitkörper aufgrund seines Raumbedarfs ungeeignet. Ferner ist bei einer derartigen Lichteinkopplung, die Durchführung in Teilbereichen des Lichtleitkörpers, die außerhalb des fokussierten Lichtstrahls liegen, ungenügend.

Ein anderer Vorschlag geht wiederum von einem gemeinsamen sowohl für die Zifferblattbeleuchtung als auch die Zeigerbeleuchtung vorgesehenen Lichtleitkörper aus und sieht, wie beispielsweise der DE-C 2 848 001 entnommen werden kann, besonders gestaltete Ein- und Auskoppelflächen an Lichtleitkörper und Zeiger vor. Dabei wird bezüglich des Zeigers eine komplizierte Formgestaltung, erhebliche Bauhöhe und ein relativ großes, die Zeigernabe abdeckendes Zeigerauge, aber auch die Tatsache, daß nicht mehrere Zeiger zentrisch übereinander angeordnet werden können, in Kauf genommen, ohne daß dadurch – bei sonst gleichen Verhältnissen – mehr Licht aus dem Lichtleitkörper in die Zeigernabe eingespeist werden würde.

Die der vorliegenden Erfindung zugrunde liegende Aufgabe bestand somit darin, für die Anzeigemittel eines Meßgerätes eine Anordnung zur Durchlichtbeleuchtung zu finden, welche gegenüber dem bekannten Stand der Technik mit vermindertem Raumbedarf und reduziertem Fertigungs- und Montageaufwand eine gleichmäßige und kontraststarke Beleuchtung sowohl der Skalen als auch der Zeiger gestattet.

Die erfindungsgemäße Lösung dieser Aufgabe sieht vor, daß zwischen dem der Lichtquelle benachbarten Bereich des Lichtleitkörpers und der der Durchführung der Zeigerwelle dienenden Öffnung Schlitze vorgesehen sind, deren lichtumlenkende Flächen im Lichtleitkörper einen Lichtkanal bilden, wobei die zueinander im wesentlichen parallelen Schlitze beidseitig einer gedachten Ebene liegen, welche zum Lichtleitkörper senkrecht steht und durch die Lichtquelle und die Zeigerwelle bestimmt ist.

Weitere vorteilhafte Maßnahmen sind in den Unteransprüchen dargestellt. Dabei ist von besonderer Bedeutung, daß es sich durch den bzw. die unmittelbar im Lichtleitkörper ausgebildeten und jeweils einer Lampe zugeordneten Lichtkanäle im Bereich der Zeigerwellendurchführung im Gegensatz zu den übrigen Bereichen des Lichtleitkörpers eine Lichtmengenkonzentration erzielen läßt. Im Sinne einer Lösung der gestellten Aufgabe wird hierfür weder zusätzlicher Raum benötigt, noch ist Fertigungs- und Montageaufwand erforderlich. Vielmehr kann bei der somit erhöhten, in die Zeigernabe einspeisbaren Lichtmenge die Bauhöhe des oder der Zeiger verringert werden, indem auf die Verwendung in ihrer Lichtleitfunktion zwar in besonderer Weise optimierter, andererseits aber kompliziert geformter Zeiger verzichtet wird. Dies bedeutet mehr designerische Freiheit und Raumgewinn, aber auch die Möglichkeit, Lichtquellen mit geringerer Leistungsaufnahme verwenden zu können.

Im folgenden sei die Erfindung anhand der beigefügten Zeichnungen näher erläutert. Es zeigen:

Fig. 1 einen Ausschnitt der Frontansicht eines Meßgerätes,

Fig. 2 einen Teilschnitt durch die Anzeige- und Beleuchtungsmittel eines Meßgerätes gemäß der Schnittlinie A in Fig. 3,

Fig. 3 eine Draufsicht auf ein Meßgerät, bei welchem Frontscheibe und Frontring, die üblicherweise den frontseitigen Abschluß bilden, abgenommen sind,

Fig. 4 einen Teilschnitt gemäß der Schnittlinie B in Fig. 3.

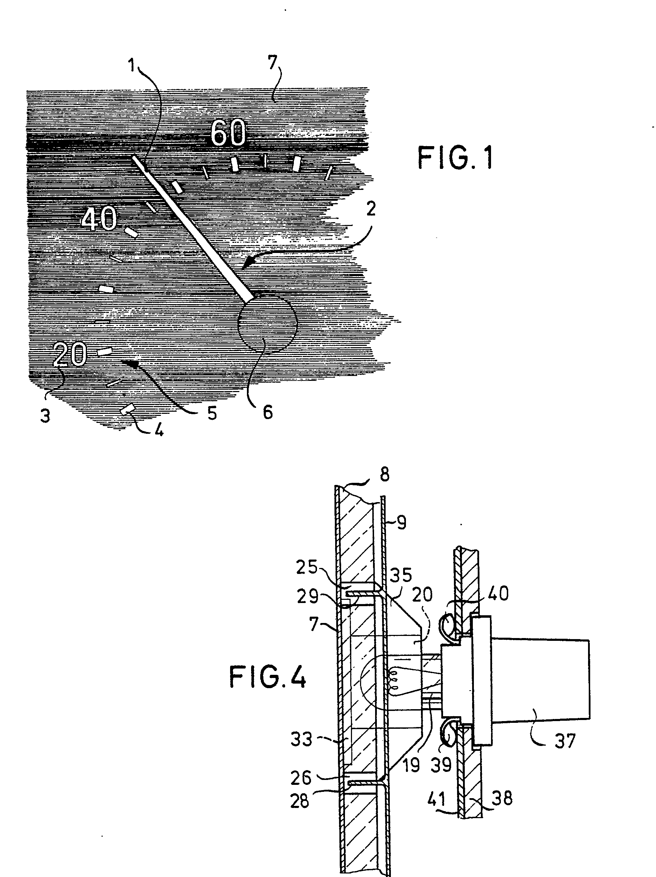

Die in Fig. 1 teilweise dargestellte Frontansicht eines Meßgerätes soll die angestrebte Dimensionierung von Skala und Zeiger sowie den mit der Durchlichtbeleuchtung erzielbaren Beleuchtungseffekt wiedergeben. Sie zeigt die schmale, im Durchlicht leuchtende Zeigerfahne 1 eines Zeigers 2, der über Ziffern 3 und Skalenstriche 4 einer Skala 5 spielt und dessen Zeigerauge 6 die leichtleitende Nabe des Zeigers 2 lichtundurchlässig abdeckt. Als Skalenträger bzw. als Zifferblatt 7 kann, wie bereits erwähnt, eine für derartige Zwecke entwickelte, lichtstreuende Folie Anwendung finden, wobei zur Steigerung des Kontrastes die Folie zunächst weiß lackiert und dann unter Ausblendung der Skala 5 dunkel gefärbt werden würde.

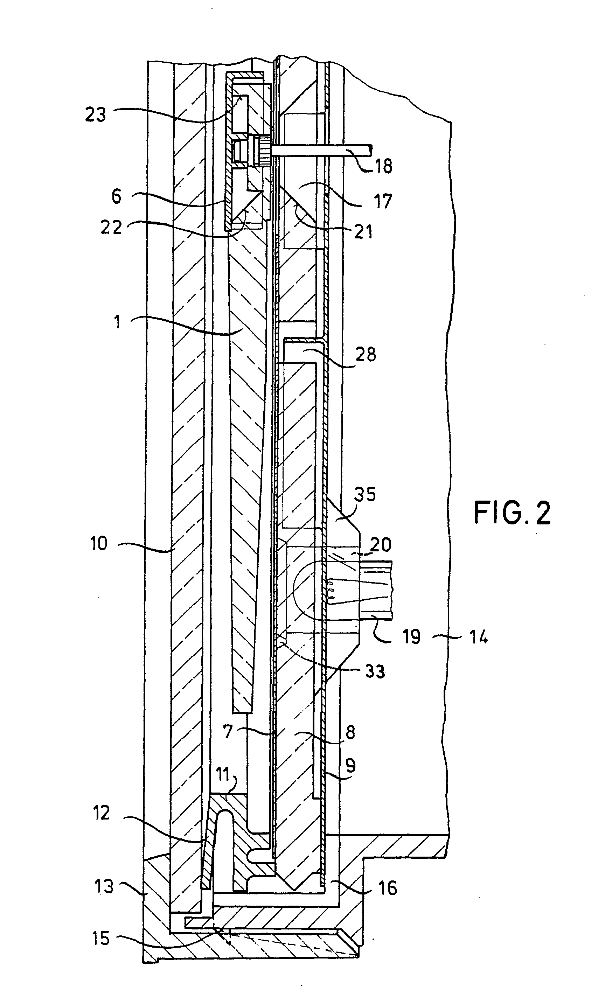

Wie der Schnittdarstellung der Fig. 2 entnommen werden kann, liegt das Zifferblatt 7 bei dem gewählten Ausführungsbeispiel unmittelbar auf einem scheibenförmigen, im wesentlichen dem Öffnungsquerschnitt des Meßgerätes entsprechenden Lichtleitkörper 8 auf. Dabei ist, um einen Austritt des Lichtes aus dem Lichtleitkörper 8 für die Beleuchtung der Ziffern 3 und der Skalenbereiche 4 zu ermöglichen, der Lichtleitkörper 8 an seiner einen Begrenzungsfläche wenigstens im Bereich der Skala 5 aufgerauht. Auf der Gegenseite ist dem Lichtleitkörper 8 ein Reflektor 9 zugeordnet, dessen Aufgabe es ist, aus dem Lichtleitkörper 8 planseitig austretendes Licht zu reflektieren und somit Lichtverluste gering zu halten sowie die Helligkeitsunterschiede verschiedenfarbiger, bei hoher Packungsdichte bis nahe an den Lichtleitkörper 8 heranreichender Bauelemente bzw. zwischen den Bauelementen liegender, lichtabsorbierender Hohlräume zu egalisieren. Ein zwischen dem Lichtleitkörper 8 und einer Frontscheibe 10 des Meßgerätes angeordneter Ring 11 dient einerseits als Blende, andererseits mit einer an ihm ausgebildeten Lippe 12 als Spielausgleichsfeder, die bewirkt, daß wenn ein das Meßgerät frontseitig abschließender Frontring 13 mit dem Gehäuse 14 des Meßgerätes verrastet ist, wobei mehrere am Umfang des Gehäuses 14 ausgebildete Nasen 15 in entsprechende, im Frontring 13 ausgebildete Hinterschnitte eingreifen, die Frontscheibe 10 an dem Frontring 13 anliegt und der Lichtleitkörper 8 zusammen mit dem Zifferblatt 7 und dem Reflektor 9 gegen am Gehäuse 14 ausgeformte Konsolen 16 gehalten wird. Eine im Lichtleitkörper 8 ausgebildete Öffnung 17 mit kegelförmiger Wandung sowie nicht näher bezeichnete Öffnungen im Reflektor 9 und in dem Ziffernblatt 7 dienen der Durchführung einer Zeigerwelle 18, an deren Ende der Zeiger 2 befestigt ist. Die Beleuchtung des Zeigers 2 erfolgt, was an sich Stand der Technik darstellt, ausgehend von einer als Lichtquelle dienenden Lampe 19, die, wie dargestellt, in eine im Lichtleitkörper 8 ausgebildete Öffnung 20 hineinragt, durch eine erste Umlenkung des im Lichtleitkörper 8 streuenden Lichtes an einer durch die Öffnung 17 gebildeten konischen Auskoppelfläche 21 sowie durch eine weitere Umlenkung an einer an der Zeigernabe ausgebildeten, ebenfalls konischen Einkoppelfläche 22. Ferner wird an der Zeigernabe austretendes Streulicht durch eine ebenfalls an der Zeigernabe ausgebildete Zylinderfläche 23 auf die Zeigerfahne 1 des Zeigers 2 konzentriert.

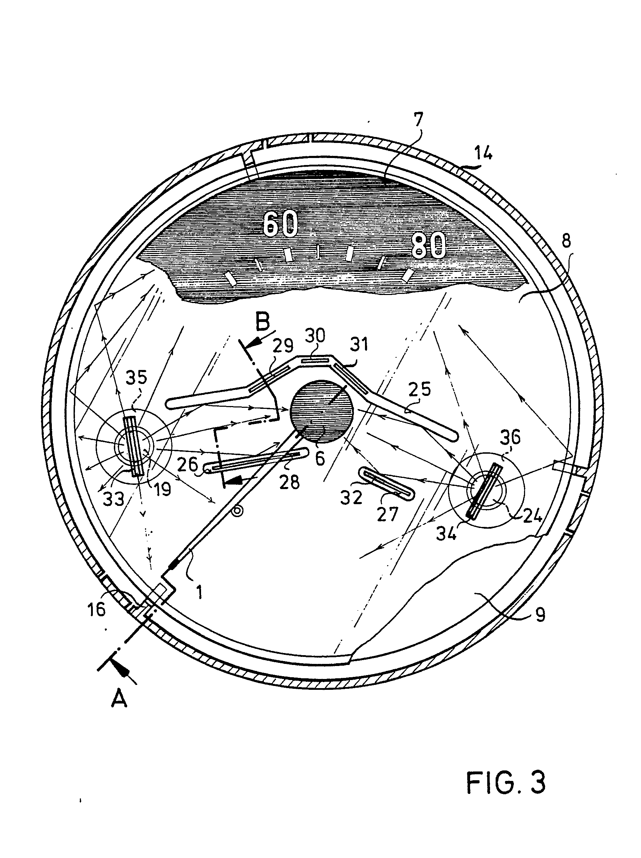

Aus der in Fig. 3 dargestellten Draufsicht, bei der die Frontscheibe 10 und der Frontring 13 des Meßgerätes nicht und das Ziffernblatt 7 nur teilweise dargestellt sind, ist ersichtlich, daß, um eine gleichmäßige Ausleuchtung des relativ großflächigen Ziffernblattes 7 zu erzielen, als weitere Lichtquelle eine Lampe 24 vorgesehen und dem Lichtleitkörper 8 in der gleichen Weise wie die Lampe 19 zugeordnet ist. Ferner ist ersichtlich, daß im Lichtleitkörper 8 vorzugsweise paarweise und im wesentlichen parallel zueinander verlaufende Schlitze 25, 26, 27 ausgebildet sind. Die Schlitze bzw. Schlitzteile liegen dabei beidseitig einer gedachten Ebene, welche zum Lichtleitkörper 2 senkrecht steht und durch die Lichtquelle 19 und die Zeigerwelle 18 bestimmt ist. Die beiderseits dieser Ebene ausgebildeten Schlitze 25, 26, 27 stellen, was zusätzlich durch die eingezeichneten Strahlengänge verdeutlicht werden soll, Lichtkanäle dar, indem durch Totalreflektion an den Schlitzwänden bewirkt wird, daß eine erheblich größere Lichtmenge als zuvor an der Auskoppelfläche 21 des Lichtleitkörpers 8 zur Verfügung steht, ohne daß dadurch die Ausleuchtung des Ziffernblattes 7 nachteilig beeinflußt wird. Eine Steigerung dieses Kanaleffektes und somit eine höhere Lichtkonzentration im Bereich der Zeigerwelle 18 wird zusätzlich dadurch erreicht, daß an dem Reflektor 9 Zungen 28, 29, 30, 31, 32 ausgebildet bzw. herausgebogen sind, die in die Schlitze 25, 26, 27 hineinragen und in die Schlitze eintretendes Streulicht reflektieren. Denkbar ist auch, daß der Lichtleitkörper 8 derart ausgebildet ist, daß der bzw. die Lichtkanäle wenigstens an einer der Begrenzungsebenen des Lichtleitkörpers 8 diesen überragen, d.h. der Lichtleitkörper 8 ungleichmäßig dick ausgebildet ist. Um das im Bereich der Lampen 19 und 24 im wesentlichen senkrecht zum Lichtleitkörper 8 flutende Licht wirkungsvoller zu nutzen, sind im Lichtleitkörper 8 quer zur Kanalrichtung V-förmige Kerben 33 und 34 angebracht. Mit dieser Maßnahme wird das Licht einerseits in die Lichtkanäle gerichtet, andererseits dem das Licht in den übrigen Teil des Lichtleitkörpers 8 streuenden Rand des Lichtleitkörpers 8 zugeführt.

Die Teilschnittdarstellung Fig. 4 stellt im wesentlichen einen Querschnitt durch einen der Lichtkanäle dar. Der Vollständigkeit halber sei anhand dieser Figur noch nachgetragen, daß die Lichtausbeute der Lampen 19 und 24 durch am Lichtleitkörper 8 angeformte konische Ansätze 35, 36 verbessert ist. Mit 37 ist der Sockel der Lampe 19 bezeichnet, der in an sich bekannter Weise mittels Bajonettverbindung an einer gehäusefesten Wand 38 gehalten ist, während mit 39 und 40 die mit einer Schaltungsplatte 41 kontaktierenden Stromzuführungen der Lampe 19 bezeichnet sind.

**Patentansprüche**

1. Anordnung zur Durchlichtbeleuchtung der Anzeigemittel eines Meßgerätes mit wenigstens einer im Innern des Meßgerätes angeordneten Lichtquelle (19) und einem der Lichtquelle (19) zugeordneten, im wesentlichen den Umrissen eines Skalen- und Ziffernblattes (7) der Anzeigemittel des Meßgerätes entsprechenden, scheibenförmigen Lichtleitkörper (8), welcher der Einkopplung von Licht in wenigstens einen lichtleitenden Zeiger (1) dient, dessen Welle (18) durch den Lichtleitkörper (8) hindurchgreift, dadurch gekennzeichnet, daß zwischen dem der Lichtquelle (19) benachbarten Bereich des Lichtleitkörpers (8) und der der Durchführung der Zeigerwelle (18) dienenden Öffnung (17) Schlitze (25, 26) vorgesehen sind, deren lichtumlenkende Flächen im Lichtleitkörper (8) einen Lichtkanal bilden, wobei die zueinander im wesentlichen parallelen Schlitze (25, 26) beidseitig einer gedachten Ebene liegen, welche zum Lichtleitkörper (8) senkrecht steht und durch die Lichtquelle (19) und die Zeigerwelle (18) bestimmt ist.

2. Anordnung nach Anspruch 1, dadurch gekennzeichnet, daß im Lichtleitkörper (8) mehrere Lichtkanäle ausgeformt sind.

3. Anordnung nach Anspruch 1, dadurch gekennzeichnet, daß im Bereich der Lichtquellen (19, 24) im Lichtleitkörper (8) V-förmige Kerben (33, 34) ausgebildet sind.

4. Anordnung nach Anspruch 1 bis 3, dadurch gekennzeichnet, daß der Lichtleitkörper (8) in den Bereichen der Lichtkanäle dicker ausgebildet ist.

5. Anordnung nach Anspruch 1 bis 4, dadurch gekennzeichnet, daß dem Lichtleitkörper (8) an dessen dem Skalen- und Ziffernblatt (7) gegenüberliegender Seite ein Reflektor (9) zugeordnet ist und daß an dem Reflektor (9) Zungen (28, 29, 30, 31, 32) ausgebildet sind, die in die im Lichtleitkörper (8) ausgeformten Schlitze (25, 26, 27) hineinragen.

**Claims**

1. Arrangement for light transmission illumination of the display means of a measuring instrument having at least one light source (19) arranged in the interior of the measuring instrument and a disc-shaped photo-conductive body (8) associated with the light source (19) and substantially corresponding to the outlines of a scaled and numbered dial (7) of the display means of the measuring instrument, this photo-conductive body serving to guide light into at least one light-conductive pointer (1), whereof the shaft (18) penetrates the photo-conductive body (8), characterized in that there are provided, between the region of the photo-conductive body (8) adjacent to the light source (19) and the opening (17) serving for penetration by the pointer shaft (18), slits (25, 26) whereof light-deflecting surfaces form a light channel in the photo-conductive body (8), the substantially mutually parallel slits (25, 26) lying on either side of an imaginary plane which is perpendicular to the photo-conductive body (8) and is determined by the light source (19) and the pointer shaft (18).

2. Arrangement according to Claim 1, characterized in that a plurality of light channels are formed in the photo-conductive body (8).

3. Arrangement according to Claim 1, characterized in that V-shaped notches (33, 34) are made in the region of the light sources (19, 24) in the photo-conductive body (8).

4. Arrangement according to Claim 1 to 3, characterized in that the photo-conductive body (8) is made thicker in the regions of the light channels.

5. Arrangement according to Claim 1 to 4, characterized in that a reflector (9) is associated with the photo-conductive body (8) at the side thereof opposite the scaled and numbered dial (7), and in that tongues (28, 29, 30, 31, 32) are made in the reflector (9) and project into the slits (25, 26, 27) made in the photo-conductive body (8).

**Revendications**

1. Dispositif pour l'éclairage par transparence des moyens d'affichage d'un appareil de mesure avec au moins une source lumineuse (19) disposée à l'intérieur de l'appareil de mesure et un corps conducteur de lumière (8) en forme de disque, associé à ladite source lumineuse et correspondant, pour l'essentiel, aux contours d'un cadran gradué et chiffré (7) des moyens d'affichage de l'appareil de mesure, qui sert à l'injection de lumière dans au moins un indicateur (1) conducteur de lumière dont l'arbre (18) passe à travers le corps conducteur de lumière (8), caractérisé par le fait que, entre la zone voisine de la source lumineuse (19) du corps conducteur de lumière (8) et l'ouverture servant de traversée à l'arbre d'indicateur (18), sont prévues des fentes (25, 26) dont les surfaces infléchissant la lumière dans le corps conducteur de lumière (8) forment un canal de lumière, les fentes (25, 26) pour l'essentiel parallèles les unes par rapport aux autres étant situées de part et d'autre d'un plan imaginaire qui est perpendiculaire au corps conducteur de lumière (8) et déterminé par la source lumineuse (19) et l'arbre d'indicateur (18).

2. Dispositif selon la revendication 1, caractérisé par le fait que dans le corps conducteur de lumière (8) sont formés plusieurs canaux de lumière.

3. Dispositif selon la revendication 1, caractérisé par le fait que dans la zone des sources lumineuses (19, 24), des entailles en forme de V (33, 34) sont pratiquées dans le corps conducteur de lumière (8).

4. Dispositif selon l'une quelconque des revendications 1 à 3, caractérisé par le fait que le corps conducteur de lumière (8) est réalisé avec une épaisseur plus grande dans les zones des canaux de lumière.

5. Dispositif selon l'une quelconque des revendications 1 à 4, caractérisé par le fait que, à la face du corps conducteur de lumière (8) opposée au cadran gradué et chiffré (7) est associé un réflecteur (9) et que sur le réflecteur (9) sont formées des languettes (28, 29, 30, 31, 32) qui s'engagent dans les fentes (25, 26, 27) pratiquées dans le corps conducteur de lumière (8).

FIG. 1

FIG.4

FIG.2

FIG. 3